Europäisches Patentamt

(19) European Patent Office

Office européen des brevets

(11) EP 0 874 245 A1

(12) EUROPEAN PATENT APPLICATION

(43) Date of publication:
28.10.1998 Bulletin 1998/44

(51) Int. Cl.⁶: $G01R\ 29/26$

(21) Application number: 97106538.8

(22) Date of filing: 21.04.1997

(84) Designated Contracting States:
AT BE CH DE DK ES FI FR GB GR IE IT LI LU MC
NL PT SE
Designated Extension States:
AL LT LV RO SI

(71) Applicant:
SCHWEIZERISCHE EIDGENOSSENSCHAFT
EIDGENÖSSISCHE TECHNISCHE
HOCHSCHULE (ETH)
8092 Zürich (CH)

(72) Inventor: Schmatz, Martin Leo
9012 St. Gallen (CH)

(74) Representative:
Blum, Rudolf Emil Ernst et al
c/o E. Blum & Co
Patentanwälte
Vorderberg 11
8044 Zürich (CH)

(54) **Method and apparatus for determining the noise characteristics of an electrical device**

(57) An apparatus for measuring the noise characteristics of a device under test (14) comprises a noise source (30) and a broadband admittance tuner (40) which are coupled to the device over a directional coupler (18). The output of the device is analyzed by a measuring block (20). A network analyzer (12) is provided for calibrating the system. The noise source (30) consists of a resistor (30a), the noise signal of which is amplified by an amplifier (30b). The output of the amplifier (30d) is fed through a step attenuator (30d). This arrangement allows the generation of noise at several equivalent noise temperatures, which can be calibrated using network analyzer (12) and a measuring block (20). The apparatus requires no factory-calibration of the noise source and allows a high accuracy because noise powers can be measured at a large number of noise temperatures and input admittances.

Fig. 2

## Description

### Technical Field

The present invention relates to a method and an apparatus for determining the noise characteristics of an electrical device according to the preamble of the independent claims. In particular, it relates to a method and apparatus for measuring a two port's noise parameters. It also relates to a broadband adjustable admittance tuner.

### Background of the Invention

The noise figure of a Device Under Test (PUT) at a specific source admittance cannot be measured directly but is determined from two output noise power measurements taken at two different equivalent temperatures $T_{hot}$ and $T_{cold}$ of the source admittance. The noise figure F may then be calculated using the following equation:

$$F = 1 + \frac{T_{DUT}}{T_0} \text{ with } T_{DUT} = \frac{T_{hot} - Y \cdot T_{cold}}{Y - 1} \tag{1}$$

where $T_{DUT}$ the equivalent noise temperature of the linear two port and Y is the ratio $P_{hot}/P_{cold}$, where $P_{hot}$ is the measured noise power at the hot source temperature and $P_{cold}$ is the measured noise power at the cold source temperature. $T_0$ is the standard temperature of 290 K.

As may be seen from equation (1), a noise source with only two different equivalent temperatures $T_{hot}$ and $T_{cold}$ is theoretically sufficient to determine the noise figure of a two port device. Until now, such a noise source has been built using a silicon diode once at zero bias and once in reverse avalanche breakthrough (R.H. Haitz, F.W. Voltmer, "Noise of a self-sustaining Avalanche Discharge in Silicon: Studies at Microwave Frequencies", Jnl. Appl. Phys., Vol. 39, No 7, pp. 3379-84, June 1968). This allows a change in equivalent source temperature between two discrete states, one being at ambient (290° K) and one at 1'000° K to 100'000° K, depending on the diode used, corresponding to an excess noise ratio (ENR; ENR = $10 \cdot \log_{10}(T_{ENR}/T_0 - 1)$) between 5 dB and 25 dB.

In practice however, the two source noise temperatures should fulfill a few conditions in order to give good measurement accuracy (A.E. Bailey, 'Microwave Measurements', second edition, Publ. Peter Peringinus, London 1989). First, the overall gain of the device under test has to remain constant between measurements of $P_{hot}$ and $P_{cold}$, which requires that the source admittance $Y_s$ does not change with the effective temperature of the source. This is difficult to achieve due to the extreme admittance change of the silicon diode between zero bias and reverse breakdown. Second, the equivalent temperatures of the noise source must be known exactly in order to accurately calculate the noise figure according to equation (1). These parameters are normally supplied by the manufacturer of the noise source and have to be recalibrated approximately once a year. Third, the effective temperatures of the noise source should fulfill equation (2) in order to minimize measurement uncertainties:

$$T_{DUT} = \sqrt{T_{hot} \cdot T_{cold}} \tag{2}$$

where $T_{DUT}$ is the equivalent noise temperature of the device under test and $T_{hot}$ and $T_{cold}$ are the equivalent noise temperatures of the noise source at the two output power states. This implies an a-priori knowledge of the noise figure of the device under test (DUT). Additionally, the noise figure may change more than 20 dB for a change in source admittance according to equation (3) below. It is therefore not possible to fulfill equation (2) for all source admittances using only one specific noise source having only two different output powers available.

The noise figure F of a linear two port varies as a function of the connected source admittance $Y_s = G_s + jB_s$ according to the equation

$$F = F_{min} + \frac{R_n}{G_s} \cdot |Y_s - Y_{opt}|^2 \tag{3}$$

where $F_{min}$ is the minimum achievable noise figure when the optimum source admittance $Y_{opt} = G_{opt} + jB_{opt}$ is presented to the input of the two port, $Y_s$ is the source admittance and $G_s$ the real part of $Y_s$. $R_n$ is a parameter with the dimension of a resistor describing the increase of noise figure when the source admittance is not at its optimum. It is sufficient for the specification of the noise performance of a two port to determine the four noise parameters $F_{min}$, $G_{opt}$, $B_{opt}$ and $R_n$. More information may be found in `IRE Standards on Methods of Measuring Noise in Linear Twoports, 1959', Proceedings of the IRE, Jan. 1960, pp 60-68.

There are several different methods for the determination of the four noise parameters $F_{min}$, $G_{opt}$, $B_{opt}$ and $R_n$ of a two port. One method varies the source admittance continuously using a mechanical tuner to find the optimum source admittance $Y_{opt}$ where the noise output power of the two port is minimal. At this optimum source admittance $Y_{opt}$ the minimum noise figure $F_{min}$ is measured. Then the noise figure is measured at a second known source admittance. This allows the noise parameter $R_n$ to be calculated.

Another method measures the noise figure of the two port at four or more known source admittances. From these measurements and equation (3), a system of equations may be specified and solved for the four noise parameters. The more different source admittances are used, the more exactly the noise parameters are calculated because of averaging of any random measurement error. This method has the advantage that the source admittance does not have to be tuned in fine steps to find the optimum source admittance. (Richard Q. Lane, 'Determination of Device Noise Parameters', Proceedings of the IEEE, Vol. 57, Aug. 1969, pp. 1461-62).

Adamian and Uhlir describe a method in `A Novel Procedure for Receiver Noise Characterization', IEEE Transactions on Instrumentation and Measurement, Vol. IM-22, June 1973, pp 181-182. This method requires only one noise figure measurement at an arbitrary source admittance at one equivalent noise temperature, and a plurality of noise power measurements at various other source admittances, the latter all at the same source noise temperature.

Another method does not measure noise figures at different known source admittances but measures the output noise powers at these admittances for one source temperature, and one noise power for one known source admittance at another source temperature. It then gives an algorithm to calculate the noise parameters directly from these power measurements (European Patent Application EP 0 391 564 A2).

The two last methods were conceived to overcome the problem of measuring the output noise power of the device under test for a non-ambient temperature noise source for many different source admittances. Instead, these two methods recommend the measurement of a plurality of noise output powers for a noise source with its equivalent temperature being at ambient, and only one output power for a higher noise source temperature, preferably with a source impedance of 50 $\Omega$.

## Summary of the Invention

As can be seen from the above discussion, all the known methods are complicated to apply and rely on a manufacturer-calibrated noise source, such as an avalanche diode. It is therefore an object of the invention to provide a apparatus and method of the type mentioned above that allows an easy and reliable measurement of the noise characteristics of a device, in particular a linear two-port, without requiring a pre-calibrated noise source.

This object is met by the device and method according to the independent claims.

By sending the signal of a noise source through an attenuator with adjustable attenuation, it becomes possible to generate noise at several equivalent noise temperatures, which e.g. allows to measure the noise figure according to Eq. (1). As will be shown in the analysis below, it is sufficient to know the relative attenuations of the attenuator in order to derive the noise figure or noise parameters of the DUT. No pre-calibrated noise source is required and all necessary calibrations and re-calibrations can be carried out immediately before the measurement, thereby reducing errors.

The method and apparatus therefore allow an accurate determination of the noise characteristics, in particular the noise figure and noise parameters of the device. It can be fully computer controlled, which further increases reliability and simplifies the operation.

In a further aspect, the present invention relates to a broad band admittance tuner that e.g. allows to easily adjust the source admittance for measuring the noise parameters of the DUT.

## Brief Description of the Drawings

The invention will be better understood and objects other than those set forth above will become apparent when consideration is given to the following detailed description thereof. Such description makes reference to the annexed drawings, wherein:

Figure 1 shows a contour plot of constant noise figures as a function of source reflection coefficient $\Gamma_S$; Minimum noise figure $F_{min}$ is 2.9 dB at $y_{opt} = 0.155 - j \cdot 0.085$ while $R_n = 10$ $\Omega$; Noise circles are shown at 3 dB, 5 dB, 8 dB, 11 dB and 14 dB respectively;

Figure 2 is a block diagram of an exemplary system which may be used in determining the noise parameters of a linear two port device;

Figure 3 illustrates the combination of all noise figures, gains and losses at the input of the DUT into two blocks: a noiseless amplifier with gain $N_0$ and a step attenuator with variable loss $A_{step}$; and

Figure 4 shows the broadband one port tuner concept implemented using switchable short circuits logarithmically spaced on a transmission line.

## Detailed Description of the Invention

### 1. Basic Concept

In the following, we discuss one embodiment of the invention suited for measuring the noise characteristics of a linear two-port. In particular, this embodiment has been optimized for allowing an automatic, computer-controlled measurement of the four noise parameters of Eq. (3).

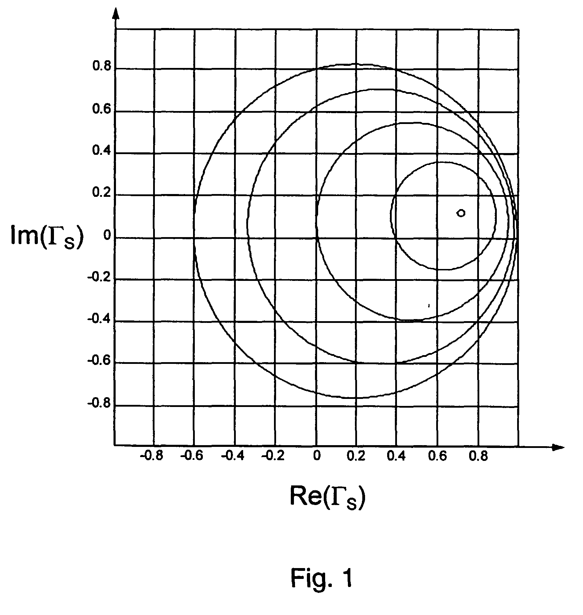

As it follows from Eq. (3), the noise figure of a linear two-port has a dependence on the source admittance or source reflection coefficient similar to the one shown in Fig. 1. In order to measure the noise parameters that govern the response depicted in Fig. 1, noise figure measurements at different source admittances are necessary.

In addition to this, the definition of the noise figure in Eq. (1) requires measurements for at least two equivalent temperatures of the noise source.

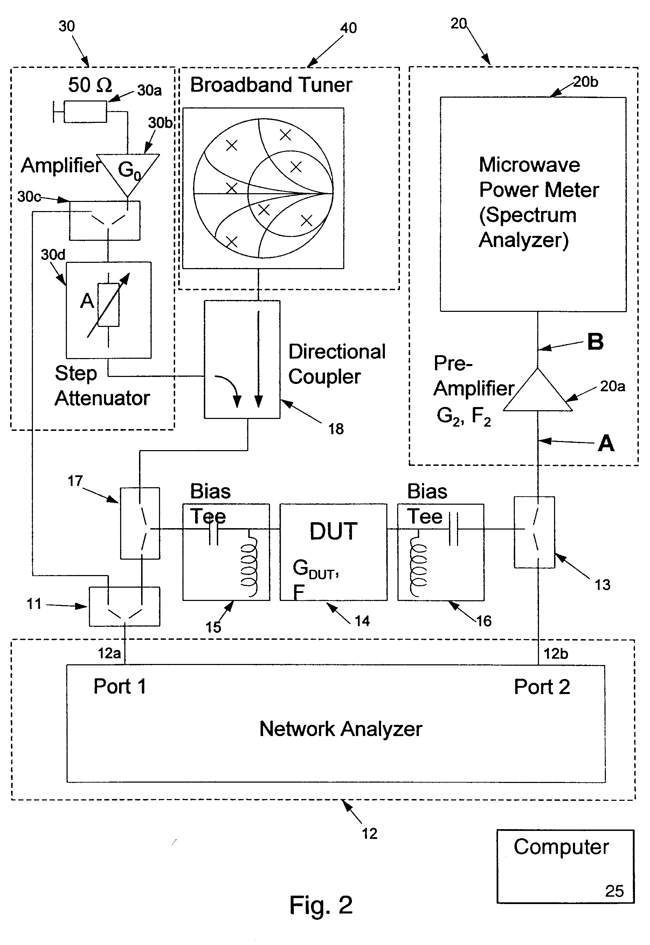

Figure 2 shows a system that allows to carry out all these measurements accurately. It comprises the following basic building blocks:

A noise source 30 comprises a 50$\Omega$ resistor 30a at room temperature, an amplifier 30b and a step attenuator 30d. The step attenuator 30d allows to attenuate the signal of amplifier 30b in a large number of different steps.

A broadband admittance tuner 40 determines the input admittance for the device under test 14. The signal from noise source 30 is coupled into the input using a directional coupler 18, such that the input noise power for the DUT 14 is governed by noise source 30 while the input admittance is determined by tuner 40.

A measuring block 20 comprises a low noise pre-amplifier 20a and a microwave power meter or spectrum analyzer 20b.

A two-port network analyzer 12 and a plurality of switches 11, 13, 17, 30c allow the calibration of the system.

A computer 25 controls the operation of all parts of the apparatus and allows an automatic calibration and measurement using the methods described below.

Noise source 30, measuring block 20 and tuner 40 are now described in more detail.

(A) Noise source 30 and measuring block 20:

The noise power is generated by broadband amplification of the thermal noise of 50 $\Omega$ resistor 30a. The output of noise amplifier 30b in a certain bandwidth B contains white noise with a power of $P_{50} \cdot F_0' \cdot G_0'$ where $P_{50}$ is the thermal noise power of the 50 $\Omega$ resistor in this bandwidth B, $F_0'$ is the noise figure and $G_0'$ the gain of the amplifier. We may postulate that this amplifier is noiseless if we mathematically compensate this by an increase of the figure for $G_0'$, e.g. $G_0 = G_0' \cdot F_0'$. This reduces the number of unknowns by one. After passing step attenuator 30d, directional coupler 18 and a bias tee 15, the available noise power presented to the DUT 14 is

$$P_{DUT} = (1 + \frac{A - 1}{G_0}) \cdot P_{50} \cdot G_0 \cdot \frac{1}{A} \tag{4}$$

where A is the overall attenuation between noise source and DUT, which is dominated by the loss of the step attenuator $A_{step}$, and $G_0$ is the combination of the gain $G_0'$ of the noise amplifier and its noise figure $F_0'$. By choosing an amplifier with a certain gain $G_0'$, we can obtain virtually every upper limit of noise temperature desired, while the lowest achievable noise temperature is at ambient for infinite attenuation. Between these two extreme values, many other noise powers may be selected by an appropriate setting of the step attenuator. By design, the change of source admittance for a change in equivalent source temperature is virtually zero. This is not the case when using a diode noise source where the source admittance changes considerably between the cold (no bias) and hot (reverse avalanche breakdown) state. Drift of the source noise power is monitored at low frequencies by integrating low frequency output power of the noise amplifier, and a drift compensation may be used.

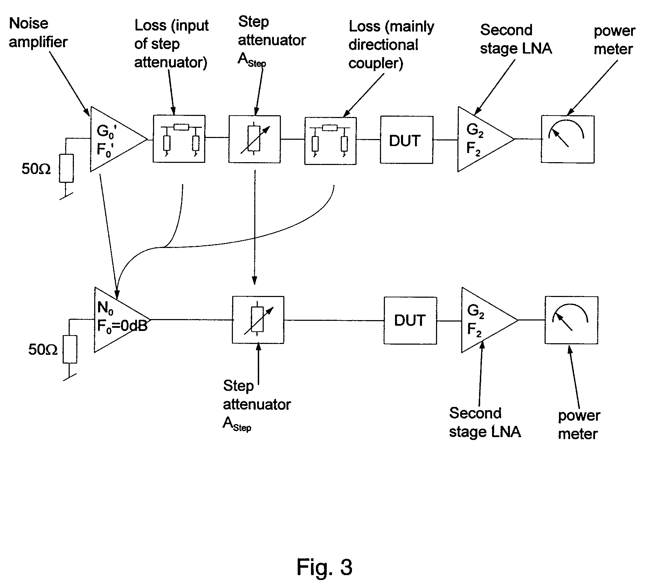

In order to measure $P_{DUT}$, the second stage amplifier 20a with gain $G_2$ and noise figure $F_2$ is required. As can be seen in Fig. 3, it is possible to combine all amplifications and all losses before the DUT into one noiseless amplifier with gain $N_0$ and a step attenuator with loss $A_{step}$. If the DUT is a loss-less (e.g. very short) transmission line, the power $P_{out}$ measured with a power meter at the output of amplifier 20a in a certain bandwidth B around a certain measurement frequency is

$$\frac{P_{out}}{P_{50}} = \left(1 + \frac{A_{step} - 1}{N_0} + \frac{F_2 - 1}{N_0 \cdot \frac{1}{A_{step}}}\right) \cdot N_0 \cdot \frac{1}{A_{step}} \cdot G_2 \qquad (5)$$

where $P_{50}$ is the thermal noise power in the bandwidth B and $A_{step}$ is the variable loss introduced by step attenuator 30d relative to its minimum loss. The value in the brackets of equation (6) corresponds to the total noise figure while the values right to the brackets stand for the overall gain of the receiver. We may convert equation (5) to

$$N_0 + A_{step} \cdot F_2 = 1 + \frac{P_{out}}{P_{50}} \cdot \frac{A_{step}}{G_2} \qquad (6)$$

If it is possible to measure $G_2$ and $A_{step}$ separately, and if we have measurements of $P_{out}$ for several (e.g. more than two) values of $A_{step}$, equation (6) implements an overdetermined system of equations for $N_0$ and $F_2$ that can be solved using a standard least squares approach.

(B) Tuner 40:

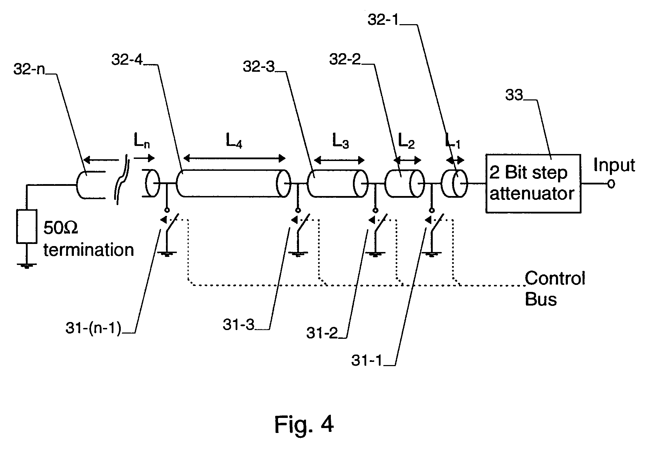

The source admittance of the noise power is dominated by the broadband one port tuner 40. As shown in Fig. 4, this tuner uses switchable short circuits 31-1 - 31-(n-1) logarithmically spaced on a 50 $\Omega$ transmission line 32-1 - 32-n. In other words, the transmission line is divided into n sections 32-1 - 32-n having length $L_1$ through $L_n$, wherein the length ratio $r = L_{i+1}/L_i$ of subsequent lines is a substantially constant value, e.g. 1.45. In a preferred embodiment, the length $L_1$ of the first section is e.g. 1/8 of the wavelength of the highest measurement frequency (6.25 mm for 6.0 GHz) and the total number n of sections is e.g. 17.

A step attenuator 33 at the input of the tuner allows to add additional losses for shifting the reflections more towards the center of the Smith chart as desired. The step attenuator 33 of the present embodiment is digitally controlled with a resolution two bits.

The source admittance may be changed by setting the step attenuator 33 and by shorting the transmission line at one of the positions 31-1 through 31-(n-1) while all other shorts are in an unused state. For each measurement frequency, a set of four to six shorts are used one after another.

This concept has several advantages compared to other tuner systems:

(1) For all measurement frequencies, there are sets of shorts available with more or less equal electrical length. This means that for all frequencies, there are source admittances available with similar magnitude and angle. This way, the tuner states cover the Smith chart evenly independent of frequency.
(2) This tuner concept is extremely broadband and is only limited by the available maximum length of the microstrip lines for low frequencies and by the minimal distance of the switchable short circuits at high frequencies.
(3) For high frequencies, the shorts close to the input of the tuner are used. The loss introduced by the transmission line and short circuits are therefore small because of the small number of shorts involved for these high frequencies. For lower frequencies, shorts with more distance to the input are used, but the loss at these frequencies is smaller. This results in a rather constant maximum reflection coefficient for all measurement frequencies.
(4) Resonances due to multiple reflections are completely eliminated provided that the unused shorts present a small reflection coefficient and that at the far end of the tuner a 50 $\Omega$ termination absorbs all power that passed the short.
(5) The loss of the tuner is minimized because no switchable through connection is used.

2. Calibration

The measurement of the noise figure according to equation (1) requires knowledge of the equivalent noise temperatures of the noise source, as well as the gain and noise contribution of all elements after the DUT. In order to get these figures, a calibration is required. Calibration of the system for a given measurement frequency range is carried out in seven steps:

(1) A S-parameter calibration is performed using the network analyzer (NWA) 12 and a standard calibration method, e.g. line-reflect-match (LPM). At the end of this calibration procedure, the DUT 14 is replaced by a through connection.

(2) The relative attenuation steps in step attenuator 30d are measured with the 0 dB setting as reference attenuation. This is done using the forward transmission measurement of the NWA from its port1 12a via relay 11 and relay 30c, the step attenuator 30d and the directional coupler 18, the relay 17, the bias tee 15, the DUT through connection 14, the bias tee 16 and the relay 13 to the NWA port2 12b at all settings of the step attenuator 30d.

(3) All possible admittances at the input of the DUT 14 dominated by the tuner 40 are measured from the port2 12b side of the NWA 12 via relay 13 and bias tee 16.

(4) The input admittance of microwave receiver 20 as presented to the DUT 14 is measured from the port1 12a side of the NWA 20 via relay 11 and relay 17, bias tee 15, DUT through connection 14, bias tee 16 and relay 13.

(5) The available loss between DUT 14 and input of the preamplifier G2 20a is determined by connecting a short, open and load respectively instead of the preamplifier G2 20a.

(6) The amplification of preamplifier 20a is measured in two steps. The NWA 12 port1 12a outputs a sine wave at the calibration frequency. The microwave power meter 20b is connected to point A in figure 2 and the sine wave power is measured. Then, preamplifier 20a is connected between points A and B and the sine wave power is measured again. The difference between the two measurements corresponds to the gain of preamplifier 20a. The filter response of the microwave receiver can be calibrated at this time as well.

(7) For all settings of attenuator 30d and tuner 40, the noise power generated in the 50 $\Omega$ resistor 30a and amplifier 30b that is received by the microwave power meter 20b is measured, and the second stage noise figure F2 and a noise source amplification factor $N_0$ is calculated according to equation (6).

Now, the second stage noise figure $F_2$ and the available noise power that is presented to the DUT 14 is known for all states of tuner 40. The absolute value of loss A' between noise amplifier 30b and DUT 14 does not need to be known. Only the relative steps are required because any offset in the loss A' is equalized by an offset in the calculated figure for $N_0$.

Because many different noise powers are measured, we can increase accuracy by averaging. The calculation of $N_0$ corresponds to a calibration of the equivalent noise source temperature $T_{eq}$ for all settings of the variable attenuator $A_{step}$.

$$T_{eq} = T_0 \cdot \left(1 + A^{\dfrac{step - 1}{N_0}}\right) \cdot \dfrac{N_0}{A_{step}} \qquad (7)$$

The available source noise temperature is calculated by

$$T_{av} = T_{eq} \cdot (1 - |\Gamma_s|^2) \qquad (8)$$

where $\Gamma_S$ is the noise source reflection coefficient.

Now the complete system is calibrated by the knowledge of the figures $F_2$, $G_2$, $A_{step}$ and $N_0$ for all tuner states. The accuracy of this system depends on the accuracy of S-parameter measurements and the linearity of power measurement and not on the accuracy of a diode noise source.

### 3. Measurement

Determination of the four noise parameters is done in two steps: First, noise figures at four or preferably more source admittances are measured according to equation (1). In the second step, the noise parameters are calculated using, for example, the method of Richard Q. Lane. This simple approach is possible because the present invention introduces a method for a very fine resolution of noise temperatures of the noise source. Additionally, the cold noise source power does not need to be at ambient temperature.

### 4. Discussion

The present method calibrates all losses between the noise source and the input of the DUT 14 and determines the equivalent noise temperatures of the noise source prior to each measurement for all measured frequency points. This is not so with the other methods, where parasitic losses have to be accounted for during the calibration of the noise source, which is done by the manufacturer, and the ENR figures are given by the manufacturer only for certain frequency points.

This method makes it possible to choose near optimum noise temperatures $T_{hot}$ and $T_{cold}$ according to equation (2) for each of the different noise figures encountered during a measurement.

6

It is also possible with the present method to increase measurement accuracy by averaging not only several measurements at two noise source temperatures, as is done with previous methods, but also by averaging measurements using more than two different noise source temperatures.

As it has become apparent above, the method can be fully controlled by computer. The computer controls the operations of network analyzer 12, switches 11, 13, 17, 30c, step attenuator 30d, tuner 40 and power meter 20. It runs calibration and measurement, thereby simplifying the operation and increasing the accuracy of the results.

It is also possible with the present method to measure 50 $\Omega$ noise figures only. For this purpose, tuner 40 and directional coupler 18 are not required and the noise source step attenuator 30d is connected to the relay 17 directly or via a fixed attenuator.

Using the method of Richard Q. Lane to calculate the noise parameters from several noise figure measurements is not intended as a limitation to this method. Any other method for calculating noise parameters from noise figure measurements will work as well (e.g.: M. Mitama, H. Katho, 'An Improved Computational Method for Noise Parameter Measurement', IEEE Trans. MTT, vol MTT-27, June 1979, pp. 612 - 615).

A person skilled in the art will recognize, that the DUT may also perform a frequency conversion, e.g. that the input and output frequencies need not be the same. The invention can therefore e.g. be used for the noise characterisation of mixers.

A person skilled in the art will recognize that the maximum noise power needs not be generated with broadband amplifier 20b, but may also be obtained by using several other means, e.g. using a diode noise source in avalanche breakdown, a gas discharge tube or a thermal source. Also, the various different source admittances may be generated using another tuner system, but the tuner 40 stated herein has the potential of virtual unlimited bandwidth, and a person skilled in the art will recognize that this type of tuner may also be used in other kinds of measurements, e.g. load pull measurements. The attenuator used in the noise source to generate different values of $A_{step}$ does not have to be a step attenuator. Any other variable attenuator, for example a continuously variable attenuator or a combination of different types, will work as well.

Further, it will be appreciated by those skilled in the art that the described technique may be used to determine noise parameter regardless of whether the source termination is described in terms of source admittance, source impedance, source reflection, or other equivalent source quality.

The terms and expressions which have been employed in the foregoing specification are used therein as terms of description and not for limitation, and there is no intention, in the use of such terms and expressions, of excluding equivalents of the features shown and described or portions of thereof, it being recognized the scope of the invention is defined and limited only by the claims which follow.

**Claims**

1. A method for determining noise characteristics of an electrical device (14) characterized by the steps of

   feeding the signal of a noise source (30a, 30b) through an variable attenuator (30d) to an input of the device (14) and measuring the noise power from an output of the device (14) for at least two different attenuation setting of said attenuator (30d).

2. The method of claim 1, wherein the noise figure (F) of the device is calculated from the measured noise powers at at least two different attenuation settings.

3. The method of one of the preceding claims, wherein the noise parameters ($F_{min}$, $G_{opt}$, $B_{opt}$, $R_n$) of the device are determined by the steps of

   varying the source admittance for the device (14),
   measuring the noise power from the device (14) for a plurality of different source admittances and for a plurality of different attenuation settings.

4. The method of claim 3, wherein the noise power is measured for at least four different source admittances.

5. The method of claim 3 or 4, wherein the noise figure (F) of the device is measured for each source admittance.

6. The method of one of the preceding claims, characterized in that prior to measuring the noise power a calibration step is carried out by measuring the relative attenuations of said attenuator (30d) at a plurality of attenuation settings.

7. The method of claim 6, characterized in that in said calibration step comprises measuring a first output signal from said attenuator at a first attenuation setting and further output signals at further attenuation settings and deriving said relative attenuations from the ratio between said fist output signal and said further output signals.

8. The method of one of the claims 6 or 7 wherein the noise power from said device (14) is measured by a measuring equipment (20) and wherein said calibration step comprises the step of replacing said device with a through connection and measuring the noise power for said different attenuation settings using said measuring equipment (20).

9. The method of one of the preceding claims, wherein said electrical device is a linear two port.

10. An apparatus for determining noise characteristics of an electrical device (14) comprising a noise source (30a, 30b) for feeding a noise signal to said device (14) and means (20) for measuring the noise power from said device characterized in that a variable attenuator (30d) is arranged between said noise source (30a, 30b) and said device (14).

11. The apparatus of claim 10 wherein said noise source (30a, 30b) comprises a thermal noise source (30a) and an amplifier (30b) for amplifying the signal from said thermal noise source (30a).

12. The apparatus of one of the claims 10 or 11 further comprising an admittance tuner (40) for determining a source admittance of said device (14).

13. The apparatus of claim 12 wherein said admittance tuner (40) comprises a transmission line divided into sections (32-1 ... 32-n) and switchable short circuits (31-1 ... 31-(n-1)) arranged between said sections, wherein said sections (32-1 ... 32-n) have different lengths ($L_1$ ... $L_n$).

14. The apparatus of claim 13 wherein said lengths are such that the ratio ($L_{i+1}:L_i$) between the lengths of consecutive lines is constant.

15. The apparatus of one of the claims 13 or 14 wherein the shortest (32-1) of said sections is arranged at an input side of said tuner (40).

16. The apparatus of one of the claims 13 - 15 wherein said tuner (40) further comprises an attenuator (33) arranged at an input side for adding a loss to said admittance.

17. The apparatus of one of the claims 13 - 16 wherein a last (32-n) of said sections is electrically terminated.

18. The apparatus of one of the claims 12 - 17 wherein a directional coupler (18) is arranged between said tuner (40), said attenuator (30d) and said device (14) connected such that the source admittance for said device is determined by said tuner (40).

19. The apparatus of one of the claims 10 - 18 further comprising a network analyzer (12) for calibration and switches (11, 13, 17, 30c) for connecting said network analyzer to points before said attenuator, to an input of said device (14), and to an output of said device (14).

20. The apparatus of one of the claims 10 - 19 further comprising a computer (25) for automatic calibration and measurement.

21. An admittance tuner having an input with variable admittance as described in one of the claims 13-17.

Fig. 1

Fig. 2

Fig. 3

**Fig. 4**

**European Patent Office**

## EUROPEAN SEARCH REPORT

Application Number

EP 97 10 6538

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | DATABASE INSPEC<br>INSTITUTE OF ELECTRICAL ENGINEERS,<br>STEVENAGE, GB<br>Inspec No. 2241831,<br>POLIVKA J: "A simple method of measuring the noise figure of low-noise microwave receivers"<br>XP002042823<br>* abstract *<br>&<br>SDELOVACI TECHNIKA, FEB. 1984,<br>CZECHOSLOVAKIA,<br>vol. 32, no. 2, ISSN 0036-9942,<br>page 46<br>--- | 1,10 | G01R29/26 |
| A | LUCERO R ET AL: "NOISE CHARACTERIZATION UNCERTAINTY OF MICROWAVE DEVICES UNDER LOW CURRENT OPERATION"<br>INTERNATIONAL MICROWAVE SYMPOSIUM, LONG BEACH, JUNE 13 - 15, 1989. VOLUMES 1 - 3 BOUND AS ONE,<br>vol. 1, INSTITUTE OF ELECTRICAL AND ELECTRONICS ENGINEERS,<br>pages 893-896, XP000077272<br>--- | 3,12,13 | |
| A | FRASER A ET AL: "REPEATABILITY AND VERIFICATION OF ON-WATER NOISE PARAMETER MEASUREMENTS"<br>MICROWAVE JOURNAL,<br>vol. 31, no. 11,<br>pages 172-176, XP000098243<br>----- | 1,10 | |

TECHNICAL FIELDS SEARCHED (Int.Cl.6)

G01R

The present search report has been drawn up for all claims

| Place of search | Date of completion of the search | Examiner |
|---|---|---|
| THE HAGUE | 7 October 1997 | Iwansson, K |

EPO FORM 1503 03.82 (P04C01)